# FASCICULE DE BREVET EUROPEEN

(11) **EP 0 683 825 B1**
(45) Date de publication et mention de la délivrance du brevet: **13.08.1997**
(21) Numéro de dépôt: 94906936.3
(22) Date de dépôt: 09.02.1994
(51) Int. Cl.: C23C 16/40

(54) **PROCEDE POUR DEPOSER UNE COUCHE MINCE SUR UN SUBSTRAT PAR PLASMA FROID DIFFERE D'AZOTE**
VERFAHREN ZUR ABSCHEIDUNG EINER DÜNNEN SCHICHT AUF EINEM SUBSTRAT DURCH ZEITVERZÖGERTES KALTES STICKSTOFFPLASMA
METHOD FOR THIN FILM DEPOSITION ON A SUBSTRATE USING REMOTE COLD NITROGEN PLASMA

(30) Priorité: 10.02.1993 FR 9301484
(43) Date de publication de la demande: 29.11.1995
(73) Titulaire: THOMSON-CSF PASSIVE COMPONENTS, 21850 Saint-Apollinaire (FR)
(72) Inventeur: CALLEBERT, Franck, F-59320 Englos (FR); SUPIOT, Philippe, F-59130 Lambersart (FR); DESSAUX, Odile, F-59800 Lille (FR); GOUDMAND, Pierre, F-59800 Lille (FR)
(74) Mandataire: Guérin, Michel
(86) Numéro de dépôt international: FR9400149
(87) Numéro de publication internationale: WO9418355

(56) Documents cités:
- EP-A- 0 030 638
- EP-A- 0 421 834
- EP-A- 0 455 551
- WO-A-91/12092
- DE-A- 4 126 759
- US-A- 4 863 755
- DATABASE WPI Section Ch, Week 9246, 29 Octobre 1992 Derwent Publications Ltd., London, GB; Class L03, AN 92-381971 & WO,A,92 18430 (SEMICONDUCTOR PROCESS LABORATORY CO., LTD.;) 29 Octobre 1992
- APPLIED OPTICS vol. 32, no. 28 , 1 Octobre 1993 , WASHINGTON pages 5561 - 5566 XP398557 RUNG-YWAN TSAI ET AL. 'Amorphous silicon and amorphous silicon nitride films prepared by a plasma-enhanced chemical vapor deposition process as optical coating materials'

## Description

La présente invention concerne un procédé pour réaliser des couches minces, homogènes et adhérentes à la surface de substrats métalliques, organiques, ou minéraux pouvant intervenir dans la réalisation de dispositifs électroniques ou micro-électroniques.

La présente invention concerne également les produits obtenus par le procédé.

L'industrie électronique utilise, depuis plusieurs décennies la technologie des matériaux faisant intervenir leurs propriétés électroniques, diélectriques, conductrices ou isolantes.

Les matériaux utilisés pour les applications électroniques ont subi d'importantes modifications afin de répondre à des soucis de performances dans des conditions d'utilisation de plus en plus sévères. Ces modifications ont poussé les industries électroniques à opérer d'importantes miniaturisations de l'ensemble de leurs composants. Ceux-ci ont donc été amenés à être présentés en couches de plus en plus minces faisant intervenir des technologies de dépôt nouvelles.

Parmi celles-ci, nous retenons essentiellement les technologies consistant à déposer sur un substrat métallique, un dépôt d'un oxyde de silicium (SiO₂), ou d'un composé à caractère céramique ou polymérique tel SiN ou de polysiloxanes. Celui-ci peut être réalisé de plusieurs manières différentes.

Par exemple pour SiO₂, le film mince peut être obtenu par condensation de vapeur d'oxyde de silicium obtenue par bombardement d'une cible de (SiO₂) par un faisceau d'ions de grande énergie.

Certains auteurs utilisent, pour créer un film de (SiO₂), la technologie de dépôt assisté par plasma dans laquelle un gaz plasmagène est excité par une décharge radiofréquence, micro-onde ou continue. Le gaz plasmagène est très souvent composé de gaz rare, seul ou en mélange à des pressions comprises entre 10⁻⁵ et 10⁻² hPa. Ce plasma de décharge est composé d'espèces ioniques, d'électrons rapides, d'atomes et/ou de molécules électroniquement et/ou vibrationnellement excitées ainsi que de photons ultraviolets. C'est dans ce milieu qu'est introduit le gaz précurseur du dépôt. Le gaz précurseur du dépôt est généralement composé d'un mélange de silane (SiH₄) et d'oxygène ou d'un gaz organo silicé tel que le tétraéthoxysilane (TEOS). Ce gaz précurseur est dissocié par le plasma et les produits de dissociation, le plus souvent radicalaires, se recombinent à la surface du substrat pour former le dépôt proprement dit. Des polysiloxanes sont obtenus de la même manière à partir de monomères tels l'hexaméthyldisiloxane par exemple.

Les principales caractéristiques de cette technique sont de fournir un dépôt dont la stoechiométrie est celle des gaz précurseurs. Elle fournit une vitesse de dépôt limitée par les regazéifications induites par l'action des vecteurs de haute énergie du plasma (ions, électrons rapides et photons U.V.) et provoque un rapide échauffement du substrat à des températures supérieures à la température de fusion des matériaux organiques classiques (T°>200°C). Cette technique expose le substrat à d'importants bombardements ioniques et électroniques et génère des processus de dégradation photochimique du substrat ainsi que du dépôt formé. La surface efficace du dépôt est déterminée par la géométrie des électrodes. Celles-ci n'excèdent pas quelques centaines de centimètres carrés. La viscosité très élevée de ce type de plasma limite l'application de cette technique à des dépôts sur des surfaces planes et empêche le dépôt d'être réalisé correctement sur des surfaces gauches.

Les techniques décrites précédemment ne fournissent pas une solution convenable pour déposer un film mince, adhèrent et assurant une bonne homogénéité de dépôt sur des surfaces planes ou gauches, à des vitesses de traitement compatibles avec un procédé à cadence élevée sur un substrat pouvant être indifféremment métallique ou polymérique.

La présente invention vise à fournir un procédé permettant de réaliser un dépôt de couche mince polymérique sur des substrats métalliques, inorganiques ou polymériques à des vitesses de traitement élevées. Les dépôts réalisés selon la présente invention ont la propriété d'être homogènes et adhérents au substrat.

Un autre but visé par cette invention est de fournir un procédé pouvant réaliser à volonté un dépôt mince et homogène sur un substrat plan ainsi qu'un film homogène sur des substrats à géométrie complexe notamment en trois dimensions.

Suivant l'invention, le procédé pour appliquer une couche mince polymérique sur un substrat métallique, inorganique ou organique, dans lequel on réalise dans une enceinte dans laquelle est situé le substrat, un plasma différé d'azote constitué essentiellement d'atomes d'azotes libres, caractérisé en ce qu'on introduit dans ladite enceinte lors de la formation du plasma différé d'azote un composé gazeux organo silicé ou germané, renfermant des groupes CH, Si (ou Ge), O ou NH.

Le procédé pour former le plasma différé d'azote a été décrit notamment dans le brevet français n° 2 616 088.

Contrairement aux plasmas obtenus par un procédé différent, le procédé ci-dessus permet de réaliser dans une zone éloignée de la zone de décharge, un plasma constitué essentiellement par des atomes d'azote libres.

Un tel plasma n'échauffe pratiquement pas le substrat. Dans le procédé décrit dans le brevet français ci-dessus, le plasma d'azote a pour effet de traiter la surface du substrat pour la rendre adhérente vis-à-vis d'un revêtement appliqué ultérieurement, c'est-à-dire à l'extérieur de l'enceinte de traitement.

Dans le cas du procédé conforme à la présente invention, la présence du composé organo-silicé ou germané dans l'enceinte à plasma permet d'obtenir sur le substrat une couche pouvant adhérer sur tout substrat. La vitesse de formation de cette couche est rapide du fait qu'elle est engendrée dans un milieu dépourvu d'effets de bombardements ioniques ou photoniques destructeurs vis-à-vis de la formation de la couche.

De préférence, ledit composé gazeux silicé est choisi parmi les alkoxysilanes, les siloxanes et les silazanes.

Selon une version préférée de l'invention, on ajoute au composé gazeux introduit dans l'enceinte et en dehors de la décharge un composé gazeux contenant de l'oxygène.

Ce composé gazeux contenant de l'oxygène peut être de l'oxygène moléculaire.

On a constaté de façon surprenante que la présence d'un gaz oxygéné, tel que l'oxygène, dans le milieu contenant le plasma d'azote et le composé gazeux organo-silicé, permettait d'augmenter considérablement la vitesse de formation de la couche diélectrique sur le substrat.

Cette constatation surprenante rend le procédé selon l'invention particulièrement intéressant sur le plan industriel, en raison de sa productivité importante par rapport à la faible énergie mise en oeuvre.

Il a été constaté par ailleurs que la nature de la couche déposée sur le substrat variait non seulement suivant la nature du composé gazeux organo-silicé utilisé mais également en fonction de la teneur en oxygène introduite dans l'enceinte à plasma.

D'autres particularités et avantages de l'invention apparaîtront encore dans la description ci-après.

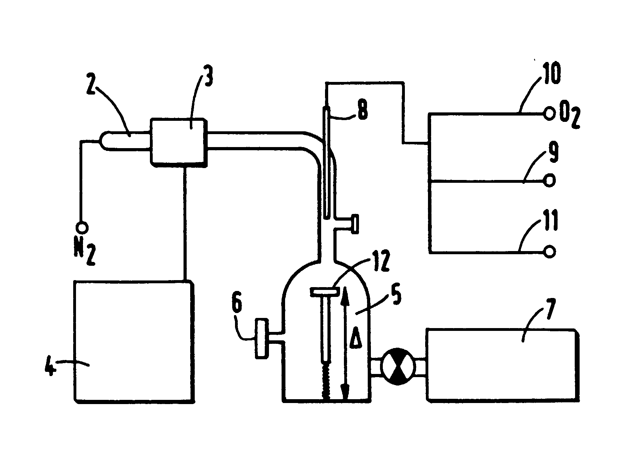

La figure unique annexée, donnée à titre d'exemple non limitatif montre le schéma d'un dispositif pour la mise en oeuvre du procédé selon l'invention.

Sur cette figure, on a représenté à gauche une source 1 d'alimentation d'azote reliée à un tube 2 qui comporte une cavité 3 dans laquelle a lieu une décharge entretenue et connectée à un générateur micro-onde 4.

La pression de l'azote à l'intérieur du tube 2 est comprise entre 1 et 20 hPa. La fréquence générée par le générateur micro-onde peut être égale à 2450, 915, 433 MHz ou toute autre fréquence légale.

Le tube 2 est relié à une enceinte de traitement 5 munie d'une jauge 6 pour mesurer la pression. L'enceinte 5 est reliée à une pompe à vide 7. Dans la partie du tube 2 située juste au-dessus de l'enceinte est introduit un injecteur 8 servant à injecter dans l'enceinte 5 un composé gazeux organo-silicé 9, de l'oxygène 10 ou un autre gaz réactif complémentaire 11.

A l'intérieur de l'enceinte 5 est situé un substrat 12 sur lequel on veut déposer une couche mince diélectrique et fortement adhérente.

Le plasma froid différé en écoulement est initié par l'effet de la décharge micro-onde sur le gaz plasmagène constitué d'azote (N2) éventuellement dopé et détendu dans le tube appelé "tube à décharge".

Le plasma froid différé en écoulement est obtenu par extraction, en régime dynamique et dans l'enceinte 5 située en dehors du champ électromagnétique, des espèces excitées de la décharge (électrons, ions, atomes, molécules vibrationnellement ou électroniquement excitées).

Seules les particules ayant une "durée de vie" suffisamment longue parviennent à atteindre la zone de traitement située en aval de la décharge.

Ce milieu réactif est caractérisé par le fait qu'il ne contient pas d'ions ou électrons en quantité appréciable.

Il est composé d'atomes d'azote libres -en général à l'état fondamental- dont la réactivité tient à leur caractère radicalaire. Ainsi les atomes d'azote sont sous la forme N(⁴S)triradical libre.

Il convient de noter que la mécanistique particulière des plasmas d'azote leur permet d'avoir une durée de vie et une extension en volume beaucoup plus importantes que celles des plasmas d'oxygène par exemple. Par ailleurs, il faut également noter l'existence d'autres gaz plasmagènes tels que: CO, CO₂, NO, NO₂, CO, H₂O.

Enfin, les propriétés d'un plasma froid en écoulement peuvent être orientées par un agent dopant par exemple: O₂, NH₃, NF₃, CF₄, SF₆.

Le procédé selon la présente invention consiste à déposer sur la surface du substrat 12 métallique ou non une couche mince adhérente et homogène. Cette couche est formée par des réactions de recombinaison hétérogènes d'espèces radicalaires à la surface du substrat. Ces espèces sont issues de la réaction entre le précurseur gazeux (composé organosilicé) et le plasma froid différé en écoulement.

Les composés organo-silicés introduits dans l'enceinte de traitement peuvent être:
un alkoxysilane de formule 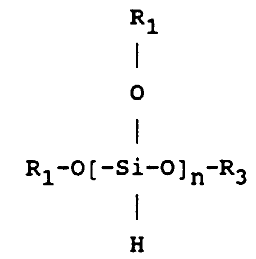 avec n ≤5
R₁, R₂, R₃ désignant : CH₃, C₂H₅, C₆H₆, H, NH₂
un siloxane de formule: 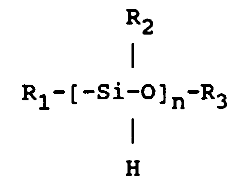 avec n ≤ 4
ou un silazane de formule: 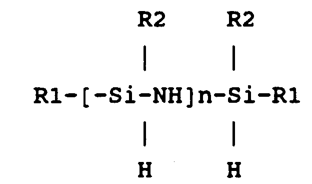 avec n <4
ou un mélange des composés monomères cités ci-dessus.

On a constaté que dans tous les cas la présence d'oxygène introduit dans l'enceinte 5 en même temps que le composé organo-silicé, favorisait considérablement la vitesse de formation de la couche sur le substrat 12.

Lorsqu'on introduit dans l'enceinte à plasma 5 un alkoxysilane et lorsque la teneur en oxygène introduite dans l'enceinte est inférieure à quelques pour cent, on obtient sur le substrat 12 une couche de silice amorphe.

Lorsqu'on introduit dans l'enceinte à plasma 5 un alkoxysilane et lorsque la teneur en oxygène est supérieure à quelques pour cent, on obtient sur le substrat 12 une couche d'un mélange de silice amorphe et de silice polymérisée.

Par ailleurs, lorsqu'on introduit dans l'enceinte à plasma 5 un siloxane et lorsque la teneur en oxygène introduite dans l'enceinte est inférieure à quelques pour cent, on obtient sur le substrat 12 une couche formée par le mélange des composés suivants:
polymère (Si-O-Si) réticulé
-Si-(CH3)1
-Si-OH
-Si-NH-Si

Lorsqu'on introduit dans l'enceinte à plasma 5 un siloxane et lorsque la teneur en oxygène introduite dans l'enceinte est supérieure à quelques pour cent, on obtient sur le substrat une couche formée par le mélange des composés suivants:
polymère (Si-O-Si) réticulé
-Si-(CH3)2
-Si-(CH3)3
-Si-OH
-Si-NH-Si

La présence des radicaux -OH, -NH ou -NH₂ est importante dans la mesure où elle gouverne les propriétés diélectriques du dépôt.

Lorsqu'on introduit dans l'enceinte à plasma 5 un silazane, on obtient sur le substrat 12 une couche formée par le mélange des composés suivants:
-Si-NH-Si
-Si-O-Si
-Si-C-Si

Le substrat peut être métallique, en céramique ou en polymère.

La couche obtenue peut présenter une épaisseur contrôlée pouvant être comprise entre 500 Å et 50 µm. La vitesse de dépôt de la couche peut être de l'ordre de 1 µm/mn.

Les substrats revêtus d'une telle couche peuvent être utilisés en tant que composants comportant une couche de passivation pour la protection électrique ou thermique, notamment dans l'électronique embarquée.

L'introduction dans le réacteur (5) d'un gaz réactif complémentaire simultanément avec un ou plusieurs des composés organosilicés précités permet de contrôler des propriétés électriques ou diélectriques de la couche mince déposée.

Les gaz introduits sont des ions (anions ou cations comportant des métaux) mis en phase gazeuse sous forme d'halogénures, d'oxhyhalogénures ou de complexes tels des acétylacétonates, des fluoroacétylacétonates,... ou d'autres agents complexants.

On forme ainsi des couches minces composites (polymère céramique) de propriétés électriques ou diélectriques contrôlées.

## Revendications

1. Procédé pour appliquer une couche mince polymérique sur un substrat (12) métallique, inorganique ou organique, dans lequel on réalise dans une enceinte (5) dans laquelle est situé le substrat (12), un plasma différé d'azote constitué essentiellement d'atomes d'azote libres, caractérisé en ce qu'on introduit dans ladite enceinte (5) lors de la formation du plasma différé d'azote un composé gazeux organo silicé ou germané, renfermant des groupes CH, Si (ou Ge), O ou NH.

2. Procédé conforme à la revendication 1, caractérisé en ce que ledit composé gazeux silice est choisi parmi les alkoxysilanes, les siloxanes et les silazanes.

3. Procédé conforme à l'une des revendications 1 ou 2, caractérisé en ce qu'on ajoute au composé gazeux introduit dans l'enceinte (5) un composé gazeux contenant de l'oxygène.

4. Procédé conforme à la revendication 3, caractérisé en ce que le composé gazeux contenant de l'oxygène est de l'oxygène moléculaire.

5. Procédé conforme à l'une des revendications précédentes, caractérisé en ce qu'on introduit en outre dans l'enceinte à plasma, un anion ou cation contenant un métal, sous forme de composé gazeux.

6. Procédé conforme à la revendication 5, caractérisé en ce que ledit composé gazeux est choisi parmi les halogénures, les oxyhalogénures, les composés organométalliques tels que les acétylacéionates, les fluoroacétylacétonates.

7. Procédé de dépôt de couche mince polymérique sur un substrat (12) métallique, inorganique ou organique, ledit dépôt étant effectué dans une enceinte (5) par recombinaison à la surface du substrat des produits issus de la dissociation d'un gaz précurseur par un gaz plasmagène issu d'un plasma généré dans une cavité (3) de décharge, caractérisé en ce que ledit plasma est un plasma différé d'azote et en ce que le gaz précurseur est un gaz organo-silicé ou organo-germané.

8. Procédé selon la revendication 7, caractérisé en ce que le plasma différé est un plasma froid différé en écoulement.

9. Procédé selon la revendication 8, caractérisé en ce que le plasma froid différé en écoulement est essentiellement constitué par des atomes d'azote libres.

10. Procédé selon l'une quelconque des revendications 8 ou 9, caractérisé en ce que la pression de l'azote est comprise entre 1 hPa et 20 hPa.

11. Procédé selon l'une quelconque des revendications 7 à 10, caractérisé en ce que le gaz précurseur du dépôt est introduit entre la sortie de la cavité (3) dans laquelle est entretenue la décharge génératrice du plasma et l'entrée de l'enceinte (5).

12. Procédé selon l'une quelconque des revendications 7 à 11, caractérisé en ce que le composé organo-silicé est choisl parmi les alkoxysilanes de formule : 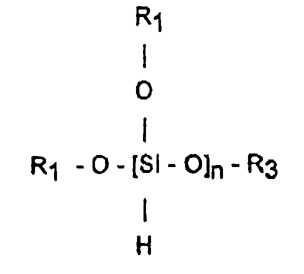 avec n inférieur ou égal à 5,
les siloxanes de formule : 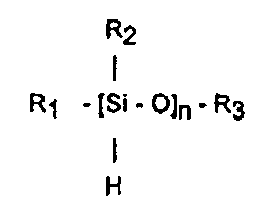 avec n inférieur ou égal à 4,
où les silazanes de formule : 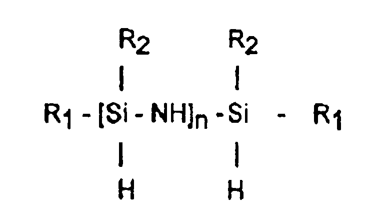 avec n inférieur à 4,
R1, R2, R3 désignant : CH₃, C₂H₅, C₆H₆, H, NH₂.

13. Procédé selon l'une quelconque des revendications 7 à 12, caractérisé en ce que de l'oxygène est introduit, lors dudit dépôt, dans ladite enceinte (5) de façon à accélérer la vitesse de dépôt de la couche polymérique.

14. Procédé selon l'une quelconque des revendications 7 à 13, caractérisé en ce qu'un élément dopant, choisi parmi les corps de formule chimique NH₃, NF₃, CF₄ ou SF₆, est introduit dans l'enceinte (5).

## Patentansprüche

1. Verfahren zum Aufbringen einer dünnen Polymerschicht auf ein metallisches, anorganisches oder organisches Substrat (12), bei dem man in einem Gefäß (5), in dem sich das Substrat (12) befindet, ein versetztes Stickstoffplasma herstellt, das hauptsächlich aus freien Stickstoffatomen besteht, dadurch gekennzeichnet, daß man in das Gefäß (5) bei der Bildung des versetzten Stickstoffplasmas eine gasförmige Organosilizium- oder Organogermanium-Verbindung einspeist, die CH-, Si- (oder Ge-), O- oder NH-Gruppen umschließt.

2. Verfahren nach Anspruch 1, dadurch gekennzeichnet, daß die siliziumhaltige gasförmige Verbindung ausgewählt wird aus den Alkoxysilanen, den Siloxanen und den Silazanen.

3. Verfahren nach einem der Ansprüche 1 oder 2, dadurch gekennzeichnet, daß man der in das Gefäß (5) eingespeisten gasförmigen Verbindung eine Sauerstoff enthaltende gasförmige Verbindung hinzufügt.

4. Verfahren nach Anspruch 3, dadurch gekennzeichnet, daß die Sauerstoff enthaltende gasförmige Verbindung molekularer Sauerstoff ist.

5. Verfahren nach einem der vorhergehenden Ansprüche, dadurch gekennzeichnet, daß man außerdem in das Plasmagefäß ein ein Metall enthaltendes Anion oder Kation in Form einer gasförmigen Verbindung einführt.

6. Verfahren nach Anspruch 5, dadurch gekennzeichnet, daß die gasförmige Verbindung aus den Halogeniden, Oxyhalogeniden, den organometallischen Verbindungen wie Acetylacetonaten, Fluoracetylacetonaten ausgewählt wird.

7. Verfahren zum Aufbringen einer dünnen Polymerschicht auf ein metallisches, anorganisches oder organisches Substrat (12), wobei die Beschichtung in einem Gefäß (5) durch Rekombination an der Oberfläche des Substrats von Produkten erfolgt, die bei der Aufspaltung eines Vorläufergases durch ein plasmagenes Gas entstehen, das von einem in einem Entladehohlraum (3) erzeugten Plasma kommt, dadurch gekennzeichnet, daß dieses Plasma ein versetztes Stickstoffplasma ist und daß das Vorläufergas ein Organosiliziumgas oder ein Organogermaniumgas ist.

8. Verfahren nach Anspruch 7, dadurch gekennzeichnet, daß das versetzte Plasma ein fließendes versetztes kaltes Plasma ist.

9. Verfahren nach Anspruch 8, dadurch gekennzeichnet, daß das fließende versetzte kalte Plasma hauptsächlich aus freien Stickstoffatomen besteht.

10. Verfahren nach einem beliebigen der Ansprüche 8 oder 9, dadurch gekennzeichnet, daß der Druck des Stickstoffs zwischen 1 hPa und 20 hPa liegt.

11. Verfahren nach einem beliebigen der Ansprüche 7 bis 10, dadurch gekennzeichnet, daß das Vorläufergas der Beschichtung zwischen dem Ausgang des Hohlraums (3), in dem die das Plasma erzeugende Entladung aufrechterhalten wird, und dem Eingang des Gefäßes (5) eingespeist wird.

12. Verfahren nach einem beliebigen der Ansprüche 7 bis 11, dadurch gekennzeichnet, daß die Organosiliziumverbindung ausgewählt wird aus den Alkoxysilanen der Formel: 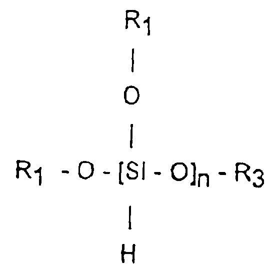 mit n ≤ 5,
aus den Siloxanen der Formel: 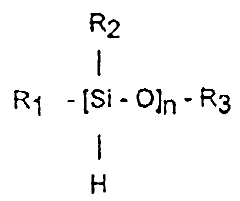 mit n ≤ 4,
oder den Silazanen der Formel: 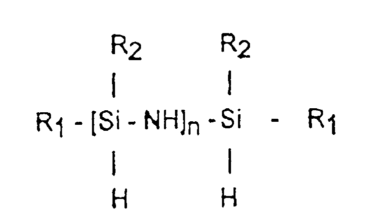 mit n < 4, wobei R1, R2, R3 stehen für CH₃, C₂H₅, C₆H₆, H, NH₂.

13. Verfahren nach einem beliebigen der Ansprüche 7 bis 12, dadurch gekennzeichnet, daß Sauerstoff bei der Beschichtung in das Gefäß (5) eingespeist wird, so daß die Geschwindigkeit des Aufwachsens der Polymerschicht beschleunigt wird.

14. Verfahren nach einem beliebigen der Ansprüche 7 bis 13, dadurch gekennzeichnet, daß ein Dotierelement, das aus den Stoffen der chemischen Formeln NH₃, NF₃, CF₄ oder SF₆ ausgewählt wird, in das Gefäß (5) eingespeist wird.

## Claims

1. Process for applying a polymeric thin layer onto a metallic, inorganic or organic substrate (12), in which a delayed nitrogen plasma consisting essentially of free nitrogen atoms is produced in a vessel (5) in which the substrate (12) is situated, characterized in that a gaseous organosilicon or -germanium compound containing CH, Si (or Ge), O or NH groups is introduced into the said vessel (5) during the formation of the delayed nitrogen plasma.

2. Process in accordance with Claim 1, characterized in that the said gaseous siliceous compound is chosen from alkoxysilanes, siloxanes and silazanes.

3. Process in accordance with either of Claims 1 and 2, characterized in that a gaseous compound containing oxygen is added to the gaseous compound introduced into the vessel (5).

4. Process in accordance with Claim 3, characterized in that the gaseous compound containing oxygen is molecular oxygen.

5. Process in accordance with one of the preceding claims, characterized in that an anion or cation containing a metal, in the form of gaseous compound, is additionally introduced into the plasma vessel.

6. Process in accordance with Claim 5, characterized in that the said gaseous compound is chosen from halides, oxyhalides and organometallic compounds such as acetylacetonates and fluoroacetylacetonates.

7. Process for deposition of a polymeric thin layer onto a metallic, inorganic or organic substrate (12), the said deposition being performed in a vessel (5) by recombination at the surface of the substrate of the products originating from the dissociation of a precursor gas by a plasma-forming gas originating from a plasma generated in a discharge cavity (3), characterized in that the said plasma is a delayed nitrogen plasma and in that the precursor gas is an organosilicon or organogermanium gas.

8. Process according to Claim 7, characterized in that the delayed plasma is a flowing delayed cold plasma.

9. Process according to Claim 8, characterized in that the flowing delayed cold plasma consists essentially of free nitrogen atoms.

10. Process according to either of Claims 8 and 9, characterized in that the nitrogen pressure is between 1 hPa and 20 hPa.

11. Process according to any one of Claims 7 to 10, characterized in that the precursor gas of the deposit is introduced between the exit of the cavity (3) in which the discharge generating the plasma is maintained and the entry of the vessel (5).

12. Process according to any one of Claims 7 to 11, characterized in that the organosilicon compound is chosen from the alkoxysilanes of formula: 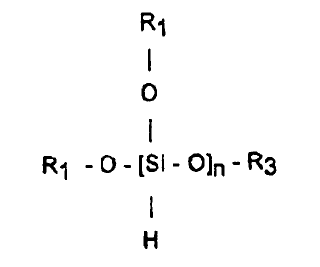 with n smaller than or equal to 5,
the siloxanes of formula: 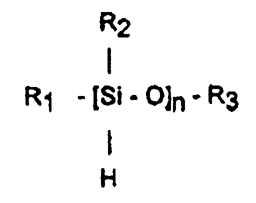 with n smaller than or equal to 4,
or the siloxanes of formula: 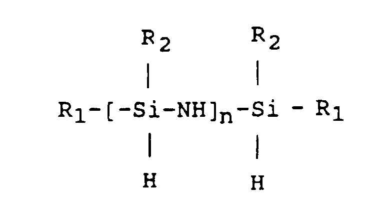 with n smaller than 4,
R₁, R₂ and R₃ denoting CH₃, C₂H₅, C₆H₆, H or NH₂.

13. Process according to any one of Claims 7 to 12, characterized in that oxygen is introduced during the said deposition into the said vessel (5) so as to accelerate the rate of deposition of the polymeric layer.

14. Process according to any one of Claims 7 to 13, characterized in that a doping component, chosen from the bodies of chemical formula NH₃, NF₃, CF₄ or SF₆, is introduced into the vessel (5).
